# EUROPEAN PATENT APPLICATION

(11) **EP 4 246 520 A1**
(43) Date of publication of application: **20.09.2023**
(21) Application number: 21950728.2
(22) Date of filing: 24.09.2021
(51) Int. Cl.: G11C 11/4091, G11C 7/06, G11C 7/08

(54) **SENSING AMPLIFICATION CIRCUIT AND DATA READOUT METHOD**

(30) Priority: 20.07.2021 CN 202110821488
(71) Applicant: Changxin Memory Technologies, Inc., Hefei City, Anhui Province 230601 (CN)
(72) Inventor: CHI, Sungsoo, Hefei City, Anhui Province 230601 (CN)
(74) Representative: Lavoix
(86) International application number: PCT/CN2021/120374
(87) International publication number: WO 2023/000490

(57) **Abstract**

Provided in the embodiments of the present application are a sensing amplification circuit and a data readout method. The sensing amplification circuit comprises: a first PMOS transistor, a source electrode of which is connected to a first signal end; a first NMOS transistor, a source electrode of which is connected to a second signal end, wherein a drain electrode of the first PMOS transistor and a drain electrode of the first NMOS transistor are connected to a first readout bit line, and gate electrodes thereof are connected to a second readout bit line; a second PMOS transistor, a source electrode of which is connected to the first signal end; a second NMOS transistor, a source electrode of which is connected to the second signal end, wherein a drain electrode of the second PMOS transistor and a drain electrode of the second NMOS transistor are connected to a first complementary readout bit line, and gate electrodes thereof are connected to a second complementary readout bit line; a first conduction unit, one end of which is connected to the first readout bit line, and the other end of which is connected to an initial bit line; a second conduction unit, one end of which is connected to the first complementary readout bit line, and the other end of which is connected to an initial complementary bit line; and a first driving unit, which is used for conducting the first PMOS transistor or the first NMOS transistor; and a second driving unit, which is used for conducting the second PMOS transistor or the second NMOS transistor.

## Description

### CROSS-REFERENCE TO RELATED APPLICATION

This application claims priority to Chinese patent application No. 202110821488.4 filed on July 20, 2021 and entitled "SENSING AMPLIFICATION CIRCUIT AND DATA READOUT METHOD", the content of which is hereby incorporated by reference in its entirety.

### TECHNICAL FIELD

The present disclosure relates to, but not limited to, a sense amplification circuit and a data reading method.

### BACKGROUND

Memory Timings are four parameters that describe the performance of Dynamic Random Access Memory (DRAM), including: CAS Latency Time (CL), Row Address to Column Address Delay (tRCD), Row Precharging Time (tRP), and Row Active Time (tRAS).

The tRCD refers to the minimum number of clock cycles required to open a row of memory and access the columns therein. In the design process of DRAMs, a time interval t between opening a row of memory and accessing columns needs to be greater than tRCD to ensure that the data in the memory cell is correctly read.

However, in the current data reading process of DRAM, the time between the opening of a row and the opening of a column is a charge sharing stage of a sense amplifier, and a delay of the tRCD is ensured by the time of the charge sharing stage, resulting in a longer reading process time of the sense amplifier and a longer data reading time of DRAM.

### SUMMARY

The embodiments of the present disclosure provide a sense amplification circuit arranged between adjacent memory arrays. The sense amplification circuit includes: a first positive channel metal oxide semiconductor (PMOS) transistor, a first negative channel metal oxide semiconductor (NMOS) transistor, a second PMOS transistor, a second NMOS transistor, a first conduction unit, a second conduction unit, a first driving unit, and a second driving unit. A source of the first PMOS transistor is connected to a first signal terminal, and the first signal terminal is configured to receive a first level signal. A source of the first NMOS transistor is connected to a second signal terminal, the second signal terminal is configured to receive a second level signal, and the first level signal is greater than the second level signal. A drain of the first PMOS transistor and a drain of the first NMOS transistor are connected to a first reading bit line, and a gate of the first PMOS transistor and a gate of the first NMOS transistor are connected to a second reading bit line. A source of the second PMOS transistor is connected to the first signal terminal. A source of the second NMOS transistor is connected to the second signal terminal. A drain of the second PMOS transistor and a drain of the second NMOS transistor are connected to a first reading complementary bit line, and a gate of the second PMOS transistor and a gate of the second NMOS transistor are connected to a second reading complementary bit line. One terminal of the first conduction unit is connected to the first reading bit line, other terminal of the first conduction unit is connected to an initial bit line, and the initial bit line is connected to a memory cell of one memory array of the adjacent memory arrays. One terminal of the second conduction unit is connected to the first reading complementary bit line, other terminal of the second conduction unit is connected to an initial complementary bit line, and the initial complementary bit line is connected to a memory cell of other memory array of the adjacent memory arrays. One terminal of the first driving unit is connected to the first reading bit line, and other terminal of the first driving unit is connected to the second reading complementary bit line, to turn on the first PMOS transistor or the first NMOS transistor. One terminal of the second driving unit is connected to the first reading complementary bit line, and other terminal of the second driving unit is connected to the second reading bit line, to turn on the second PMOS transistor or the second NMOS transistor.

The embodiments of the present disclosure further provide a data reading method based on the above sense amplification circuit. The method includes operations as follows. A row selection signal and a column selection signal are provided to turn on a selected memory cell. An electrical signal corresponding to logic "1" to the first signal terminal is provided, and an electrical signal corresponding to logic "0" to the second signal terminal is provided.

### BRIEF DESCRIPTION OF THE DRAWINGS

FIGS. 1 to 3 illustrate schematic diagrams of sense amplification circuits according to an embodiment of the present disclosure.
FIG. 4 illustrates a timing diagram of each control signal of a sense amplification circuit in a data reading method according to another embodiment of the present disclosure.
FIGS. 5 to 9 illustrate schematic diagrams of circuit states of each sense amplification circuit corresponding to a respective stage in a data reading method according to another embodiment of the present disclosure.

### DETAILED DESCRIPTION

TRCD refers to the minimum number of clock cycles required to open a row of memory and access the columns therein. In the design process of DRAMs, a time interval t from the opening of a row to the opening of a column needs to be greater than tRCD to ensure that the data in the memory cell is correctly read.

In the current data reading process of DRAM, the time between the opening of a row and the opening of a column is a charge sharing stage of a sense amplifier, and a delay of the tRCD is ensured by the time of the charge sharing stage, resulting in a longer reading process time of the sense amplifier and a longer data reading time of DRAM.

In the embodiments of the present disclosure, the delay of the tRCD is ensured by different reading stages of the sense amplifier, so as to shorten the reading process time of the sense amplifier, thereby shortening the data reading time of the DRAMs.

Specifically, one embodiment of the present disclosure provides a sense amplification circuit arranged between adjacent memory arrays. The sense amplification circuit includes: a first PMOS transistor, a first NMOS transistor, a second PMOS transistor, a second NMOS transistor, a first conduction unit, a second conduction unit, a first driving unit, and a second driving unit. A source of the first PMOS transistor is connected to a first signal terminal, and the first signal terminal is configured to receive a first level signal. A source of the first NMOS transistor is connected to a second signal terminal, the second signal terminal is configured to receive a second level signal, and the first level signal is greater than the second level signal. A drain of the first PMOS transistor and a drain of the first NMOS transistor are connected to a first reading bit line, and a gate of the first PMOS transistor and a gate of the first NMOS transistor are connected to a second reading bit line. A source of the second PMOS transistor is connected to the first signal terminal. A source of the second NMOS transistor is connected to the second signal terminal. A drain of the second PMOS transistor and a drain of the second NMOS transistor are connected to a first reading complementary bit line, and a gate of the second PMOS transistor and a gate of the second NMOS transistor are connected to a second reading complementary bit line. One terminal of the first conduction unit is connected to the first reading bit line, other terminal of the first conduction unit is connected to an initial bit line, and the initial bit line is connected to a memory cell of one memory array of the adjacent memory arrays. One terminal of the second conduction unit is connected to the first reading complementary bit line, other terminal of the second conduction unit is connected to an initial complementary bit line, and the initial complementary bit line is connected to a memory cell of other memory array of the adjacent memory arrays. One terminal of the first driving unit is connected to the first reading bit line, and other terminal of the first driving unit is connected to the second reading complementary bit line, to turn on the first PMOS transistor or the first NMOS transistor. One terminal of the second driving unit is connected to the first reading complementary bit line, and other terminal of the second driving unit is connected to the second reading bit line, to turn on the second PMOS transistor or the second NMOS transistor.

A person of ordinary skill in the art may understand that, in various embodiments of the present disclosure, many technical details are proposed for the reader to better understand the present disclosure. However, even without these technical details and various changes and modifications according to the following embodiments, the technical solutions claimed in the present disclosure may be realized.

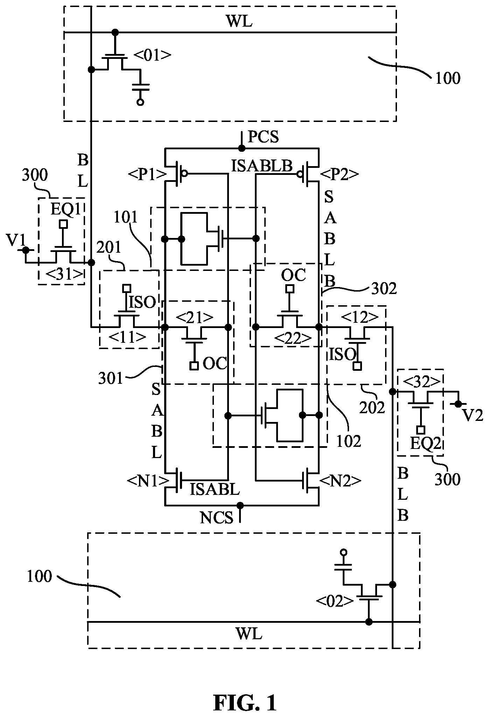

FIGS. 1 to 3 illustrate schematic diagrams of a sense amplification circuit according to an embodiment of the present disclosure. The sense amplification circuit provided in this embodiment in further detail with reference to the drawings will be described in the following, specifically as follows.

Referring to FIGS. 1 to 3, the sense amplification circuit includes:
a first PMOS transistor <P1>, a source of which is connected to a first signal terminal, and the first signal terminal is configured to receive a first level signal (Positive Cell Storing Signal, PCS).

A first NMOS transistor <N1>, a source of which is connected to a second signal terminal, and the second signal terminal is configured to receive a second level signal (Negative Cell Storing Signal, NCS).

A drain of the first PMOS transistor <P1> and a drain of the first NMOS transistor <N1> are connected to a first reading bit line SABL, and a gate of the first PMOS transistor <P1> and a gate of the first NMOS transistor <N1> are connected to a second reading bit line ISABL.

For the first PMOS transistor <P1> and the first NMOS transistor <N1>, since the gate of the first PMOS transistor <P1> and the gate of the first NMOS transistor <N1> have the same connection relationship, that is, based on different levels of the second reading bit line ISABL, when the first PMOS transistor <P1> or the first NMOS transistor <N1> is turned on, only one of the first PMOS transistor <P1> and the first NMOS transistor <N1> is turned on.

The first level signal PCS is greater than the second level signal NCS. In some embodiments, the first level signal PCS is a high level corresponding to logic "1", and the second level signal NCS is a low level corresponding to logic "0".

Specifically, after the first PMOS transistor <P1> is turned on, the first signal terminal is communicated with the first reading bit line SABL, so that the first reading bit line SABL is pulled up to the first level signal PCS, and then the initial bit line BL is pulled up to the first level signal PCS, thereby causing the data read by the memory through the initial bit line BL to be the high level of the first level signal PCS corresponding to logic "1". When the first NMOS transistor <N1> is turned on, the second signal terminal is communicated with the first reading bit line SABL, so that the first reading bit line SABL is pulled down to the second level signal NCS, and then the initial bit line BL is pulled down to the second level signal NCS, thereby causing the data read by the memory through the initial bit line BL to be the low level of the second level signal NCS corresponding to logic "0".

The second PMOS transistor <P2>, a source of which is connected to the first signal terminal.

A second NMOS transistor <N2>, a source of which is connected to the second signal terminal.

A drain of the second PMOS transistor <P2> and a drain of the second NMOS transistor <N2> are connected to the first reading complementary bit line SABLB, and a gate of the second PMOS transistor <P2> and a gate of the second NMOS transistor <N2> are connected to the second reading complementary bit line ISABLB.

For the second PMOS transistor <P2> and the second NMOS transistor <N2>, since the gate of the second PMOS transistor <P2> and the gate of the second NMOS transistor <N2> have the same connection relationship, that is, based on different levels of the second complementary bit line ISABLB, when the second PMOS transistor <P2> or the second NMOS transistor <N2> is turned on, only one of the second PMOS transistor <P2> and the second NMOS transistor <N2> is turned on.

Specifically, after the second PMOS transistor <P2> is turned on, the first signal terminal is communicated with the first reading complementary bit line SABLB, thereby the first reading complementary bit line SABLB is pulled up to the first level signal PCS, and then the initial complementary bit line BLB is pulled up to the first level signal PCS, thereby causing the data read by the memory through the initial complementary bit line BLB to be the high level of the first level signal PCS corresponding to logic "1". When the second NMOS transistor <N2> is turned on, the second signal terminal is communicated with the first reading complementary bit line SABLB, so that the first reading complementary bit line SABLB is pulled down to the second level signal NCS, and then the initial complementary bit line BLB is pulled down to the second level signal NCS, thereby causing the data read by the memory through the initial complementary bit line BLB to be the low level of the second level signal NCS corresponding to logic "0".

It should be noted that for the first PMOS transistor <P1>, the first NMOS transistor <N1>, the second PMOS transistor <P2>, and the second NMOS transistor <N2>, the specific connection mode of the "source" and "drain" does not constitute a limitation of this embodiment. In other embodiments, "drain" may be used instead of "source", and "source" may be used instead of "drain".

The first conduction unit 201, one terminal of which is connected to the first reading bit line SABL, other terminal of which is connected to an initial bit line BL, and the initial bit line BL is connected to a memory cell of one memory array 100 of adjacent memory arrays 100.

The second conduction unit 202, one terminal of which is connected to the first reading complementary bit line SABLB, other terminal of which is connected to an initial complementary bit line BLB, and the initial complementary bit line BLB is connected to a memory cell of other memory array 100 of the adjacent memory arrays 100.

When the first conduction unit 201 is turned on, the initial bit line BL is communicated with the first reading bit line SABL, that is, the levels of the initial bit line BL and the first reading bit line SABL are the same; when the second conduction unit 202 is turned on, the initial complementary bit line BLB is communicated with the first reading complementary bit line SABLB, that is, the levels of the initial complementary bit line BLB and the first complementary bit line SABLB are the same.

Specifically, in some embodiments, the first conduction unit 201 includes a first isolation MOS transistor <11>, a source of which is connected to the first reading bit line SABL and a drain of which is connected to the initial bit line BL. The second conduction unit 202 includes a second isolation MOS transistor <12>, a source of which is connected to the first reading complementary bit line SABLB and a drain of which is connected to the initial complementary bit line BLB. A gate of the first isolation MOS transistor <11> and a gate of the second isolation MOS transistor <12> are configured to receive an isolation signal (Bit Line and SABL Isolation Signal, ISO), and based on the isolation signal ISO, the initial bit line BL is enabled to be electrically connected with the first reading bit line SABL, and the initial complementary bit line BLB is enabled to be electrically connected with the first reading complementary bit line SABLB.

It should be noted that, for the first isolation MOS transistor <11> and the second isolation MOS transistor <12>, the specific connection mode of the "source" and "drain" does not constitute a limitation on this embodiment, and in other embodiments, "drain" may be used instead of "source", and "source" may be used instead of "drain". In addition, this embodiment does not limit the types of the first isolation MOS transistor <11> and the second isolation MOS transistor <12>. In a specific application, the first isolation MOS transistor <11> and the second isolation MOS transistor <12> may be NMOS transistors or PMOS transistors.

In this embodiment, the initial bit line BL is connected to the first memory cell through the first switching transistor <01>, and the initial complementary bit line BLB is connected to the second memory cell through the second switching transistor <02>.

The first memory cell and the second memory cell are configured to store opposite data, that is, when the first memory cell stores the high level corresponding to logic "1", the second memory cell stores the low level corresponding to logic "0"; when the first memory cell stores the low level corresponding to logic "0", the second memory cell stores the high level corresponding to logic "1".

For the first switching transistor <01> and the second switching transistor <02>, a gate of the first switching transistor <01> is connected to a word line WL, a source of the first switching transistor <01> is connected to the initial bit line BL, a drain of the first switching transistor <01> is connected to the first memory cell; a gate of the second switching transistor <02> is connected to the word line WL, a source of the second switching transistor <02> is connected to the initial complementary BLB, and a drain of the second switching transistor <02> is connected to the second memory cell.

The word line WL is configured to be turned on based on a row selection signal. When the word line WL is turned on, the switching transistor connected to the word line WL is turned on, and the charge of the memory cell is shared on the initial bit line BL or the initial complementary bit line BLB. The initial bit line BL or the initial complementary bit line BLB is turned on based on a column selection signal, the memory reads data when the initial bit line BL or the initial complementary bit line BLB is turned on.

It should be noted that, for the first switching transistor <01> and the second switching transistor <02>, the specific connection mode of the "source" and "drain" does not constitute a limitation on this embodiment, and in other embodiments, "drain" may be used instead of "source", and "source" may be used instead of "drain". In addition, this embodiment does not limit the types of the first switching transistor <01> and the second switching transistor <02>. In a specific application, the first switching transistor <01> and the second switching transistor <02> may be NMOS transistors or PMOS transistors.

The first driving unit 101, one terminal of which is connected to the first reading bit line SABL, and other terminal of which is connected to the second reading complementary bit line ISABLB, to turn on the first PMOS transistor <P1> or the first NMOS transistor <N1>.

The second driving unit 102, one terminal of which is connected to the first reading complementary bit line SABLB, and other terminal of which is connected to the second reading bit line ISABL, to turn on the second PMOS transistor <P2> or the second NMOS transistor <N2>.

Specifically, it can be seen from the above that the first memory cell and the second memory cell are configured to store opposite data. When the first switching transistor <01> and the second switching transistor <02> are turned on, the levels of the initial bit line BL and the initial complementary bit line BLB are opposite. When the first isolation MOS transistor <11> and the second isolation MOS transistor <12> are turned on, the levels of the initial bit line BL and the first reading bit line SABL are the same, and the levels of the initial complementary bit line BLB and the first reading complementary bit line SABLB are the same, that is, the levels of the first reading bit line SABL and the first reading complementary bit line SABLB are different. After precharging the sense amplification circuit, the levels of the first reading bit line SABL, the first reading complementary bit line SABLB, the second reading bit line ISABL, and the second reading complementary bit line ISABLB are the same, and the first driving unit 101 and the second driving unit 102 are charged during precharging. When the first isolation MOS transistor <11> and the second isolation MOS transistor <12> are turned on, the levels of the first reading bit line SABL and the first reading complementary bit line SABLB change in the opposite direction, and in this case, the first driving unit 101 and the second driving unit 102 discharge in order to delay the level changes of the first reading bit line SABL and the first reading complementary bit line SABLB. Since the levels of the first reading bit line SABL and the first reading complementary bit line SABLB change in opposite directions and the discharge directions of the first driving unit 101 and the second driving unit 102 are opposite, so that the second reading bit line ISABL and the second reading complementary bit line ISABLB change in different directions, thereby when the first PMOS transistor is turned on, the second NMOS transistor is also turned on, and when the second PMOS transistor is turned on, the first NMOS transistor is also turned on. In this case, the first reading bit line SABL and the first reading complementary bit line SABLB are pulled up or pulled down under the action of the first level signal PCS and the second level signal NCS respectively, and are synchronized to the initial bit line BL and the initial complementary bit line BLB, thereby completing the data reading of the memory.

In one example, referring to FIG. 1, the first driving unit 101 includes a first driving MOS transistor, a source and a drain of the first driving MOS transistor are connected to a first reading bit line SABL, and a gate of the first driving MOS transistor is connected to a second reading complementary bit line ISABLB; the second driving unit 102 includes a second driving MOS transistor, a source and a drain of the second driving MOS transistor are connected to the first reading complementary bit line SABLB and a gate of the second driving MOS transistor is connected to the second reading bit line ISABL.

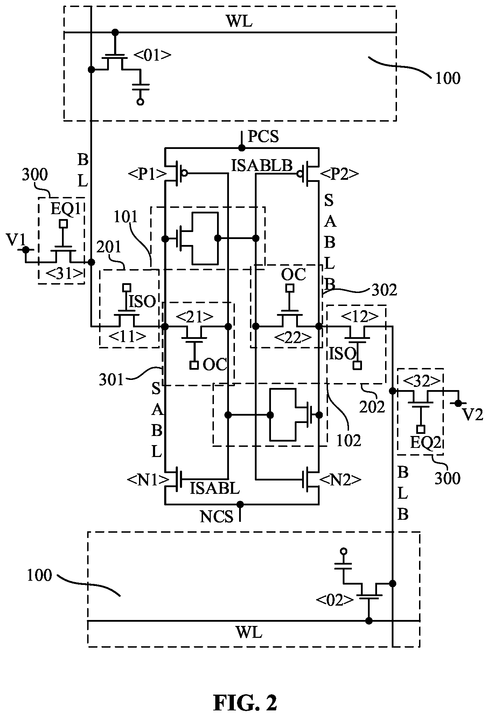

In another example, referring to FIG. 2, the first driving unit 101 includes a first driving MOS transistor, a source and a drain of the first driving MOS transistor are connected to a second reading complementary bit line ISABLB, and a gate of the first driving MOS transistor is connected to the first reading bit line SABL; the second driving unit 102 includes a second driving MOS transistor, a source a drain of the second driving MOS transistor are connected to the second reading bit line ISABL and a gate of the second driving MOS transistor is connected to the first reading complementary bit line SABLB.

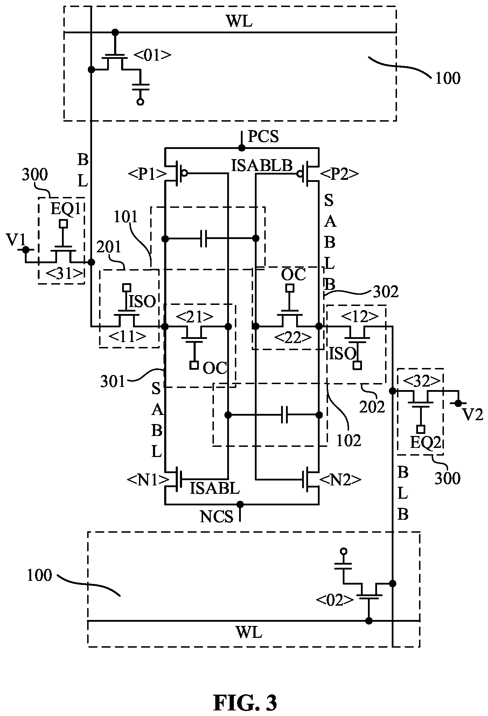

In still another example, referring to FIG. 3, the first driving unit 101 includes a first driving capacitance, one terminal of the first driving capacitance is connected to the first reading bit line SABL, and other terminal of the first driving capacitance is connected to the second reading complementary bit line ISABLB; the second driving unit 102 includes a second driving capacitance, one terminal of the second driving capacitance is connected to the first reading complementary bit line SABLB, and other terminal of the second driving capacitance is connected to the second reading bit line ISABL.

Compared with the capacitance, the MOS transistor as the equivalent capacitance can complete the corresponding function in a smaller device size. Therefore, by using the MOS transistor as the equivalent capacitance for driving, the layout area of the sense amplification circuit may be reduced, thereby reducing the layout area of the memory and increasing the integration level of the memory.

With continued reference to FIGS. 1 to 3, the sense amplification circuit further includes: a precharging unit 300. that is configured to, according to the precharging signal, precharge the initial bit line BL, the first reading bit line SABL, the second reading bit line ISABL, the initial complementary bit line BLB, the first reading complementary bit line SABLB, and the second reading complementary bit line ISABLB to a preset voltage.

Specifically, the precharging signal includes a first precharging signal EQ1 and a second precharging signal EQ2, the preset voltage includes a first preset voltage V1 and a second preset voltage V2, and the precharging unit 300 includes: a first precharging MOS transistor <31> that is configured to, according to the first precharging signal EQ1, precharge a voltage of the initial bit line BL, the voltage of the first reading bit line SABL, and the voltage of the second reading bit line ISABL to the first preset voltage V1; the second precharging MOS transistor <32> that is configured to, according to the second precharging signal EQ2, precharge the voltage of the initial complementary bit line BLB, the first reading complementary bit line SABLB, and the voltage of the second reading complementary bit line ISABLB to the second preset voltage V2.

Specifically, a gate of the first precharging MOS transistor <31> is configured to receive the first precharging signal EQ1, a source of the first precharging MOS transistor <31> is configured to receive the first preset voltage V1, and a drain of the first precharging MOS transistor <31> is connected to the initial bit line BL; a gate of the second precharging MOS transistor <32> is configured to receive the second precharging signal EQ2, a source of the second precharging MOS transistor <32> is configured to receive the second preset voltage V2, and a drain of the second precharging MOS transistor <32> is connected to the initial complementary bit line BLB.

In one example, the first precharging signal EQ1 and the second precharging signal EQ2 are the same, that is, the first precharging MOS transistor <31> and the second precharging MOS transistor <32> are turned on according to the same precharging signal (Bit Line Equalizing Signal, EQ).

In another example, the first preset voltage V1 and the second preset voltage V2 are the same for receiving the same preset voltage V_{BLP}. In this embodiment, the preset voltage V_{BLP}=1/2V_{DD}, where V_{DD} is the internal power supply voltage of the chip. In some embodiments, the precharging voltage V_{BLP} may be set according to a specific application scenario.

It should be noted that, for the first precharging MOS transistor <31> and the second precharging MOS transistor <32>, the specific connection mode of the "source" and "drain" does not constitute a limitation on this embodiment, and in other embodiments, "drain" may be used instead of "source", and "source" may be used instead of "drain". In addition, this embodiment does not limit the types of the first precharging MOS transistor <31> and the second precharging MOS transistor <32>. In a specific application, the first precharging MOS transistor <31> and the second precharging MOS transistor <32> may be NMOS transistors or PMOS transistors.

With continued reference to FIGS. 1 to 3, the sense amplification circuit further includes a first offset cancellation unit 301 and a second offset cancellation unit 302. The first reading bit line SABL is connected to the second reading bit line ISABL through the first offset cancellation unit 301, The first reading complementary bit line SABLB is connected to the second reading complementary bit line ISABLB through the second offset cancellation unit 302.

Specifically, the first offset cancellation unit 301 includes a first offset cancellation MOS transistor <21>, a source of the first offset cancellation MOS transistor <21> is connected to the first reading bit line SABL, and a drain of the first offset cancellation MOS transistor <21> is connected to the second reading bit line ISABL. The second offset cancellation unit 302 includes a second offset cancellation MOS transistor <22>, a source of the second offset cancellation MOS transistor <22> is connected to the first reading complementary bit line SABLB, and a drain of the second offset cancellation MOS transistor <22> is connected to the second reading complementary bit line ISABLB. A gate of the first offset cancellation MOS transistor <21> and a gate of the second offset cancellation MOS transistor <22> are configured to receive an offset cancellation signal (Offset Cancelling Signal, OC), and based on the offset cancellation signal OC, a device difference between the first PMOS transistor <P1> and the second PMOS transistor <P2> is enabled to be cancelled, and a device difference between the first NMOS transistor <N1> and the second NMOS transistor <N2> is enabled to be cancelled.

It should be noted that, for the first offset cancellation MOS transistor <21> and the second offset cancellation MOS transistor <22>, the specific connection mode of the "source" and "drain" does not constitute a limitation on this embodiment, and in other embodiments, "drain" may be used instead of "source", and "source" may be used instead of "drain". In addition, this embodiment does not limit the types of the first offset cancellation MOS transistor <21> and the second offset cancellation MOS transistor <22>. In a specific application, the first offset cancellation MOS transistor <21> and the second offset cancellation MOS transistor <22> may be NMOS transistors or PMOS transistors.

A memory cell connected to the initial bit line and a memory cell connected to the initial complementary bit line respectively store a level greater than the preset voltage and a level less than the preset voltage, that is, after the two memory cells perform data sharing on the initial bit line and the initial complementary bit line respectively, the levels of the initial bit line and the initial complementary bit line are opposite. The first conduction unit and the second conduction unit are turned on, the initial bit line and the first reading bit line are electrically connected, and the initial complementary bit line and the first reading complementary bit line are electrically connected, so that the levels of the first reading bit line and the first reading complementary bit line are different. After precharging the sense amplification circuit, the levels of the first reading bit line, the first reading complementary bit line, the second reading bit line, and the second reading complementary bit line are the same, and the first driving unit and the second driving unit are charged during precharging. When the first conduction unit and the second conduction unit are turned on, the levels of the first reading bit line and the first reading complementary bit line change in the opposite direction. In this case, in order to delay the level changes of the first reading bit line and the first reading complementary bit line, the first driving unit and the second driving unit are discharged. Since the first reading bit line and the first reading complementary bit line change in opposite directions and the first driving unit and the second driving unit discharge in opposite directions, the second reading bit line and the second reading complementary bit line change in different directions, thereby when the first PMOS transistor is turned on, the second NMOS transistor is also turned on, and when the second PMOS transistor is turned on, the first NMOS transistor is also turned on. In this case, the first reading bit line and the first reading complementary bit line are pulled up to the high level of logic "1" or pulled down to the low level of logic "0" under the action of the first level signal and the second level signal respectively, and are synchronized to the initial bit line and the initial complementary bit line, thereby completing the data reading of the memory.

It should be noted that, in order to highlight the innovative part of the present disclosure, the unit that is not closely related to solving the technical problem set forth in the present disclosure is not introduced in this embodiment, but this does not indicate that there are no other units in the present embodiment; A skilled person in the art will understand that the above embodiments are specific embodiments of the present disclosure, and in practical application, various changes may be made thereto in form and details without departing from the spirit and scope of the present disclosure.

Another embodiment of the present disclosure provides a data reading method. Based on the sense amplification circuit provided in the above embodiments, the method includes operations as follows. A row selection signal and a column selection signal are provided to turn on a selected memory cell. An electrical signal corresponding to logic "1" is provided to the first signal terminal, and an electrical signal corresponding to logic "0" is provided to the second signal terminal.

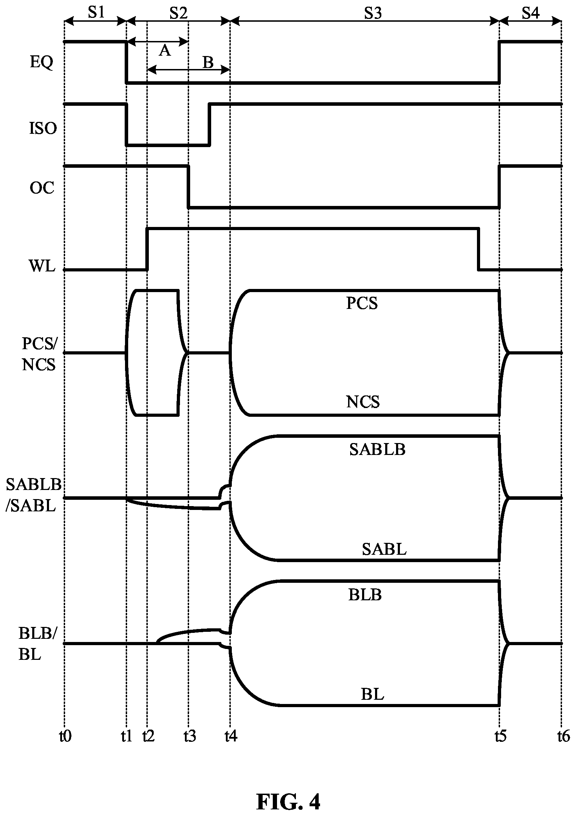

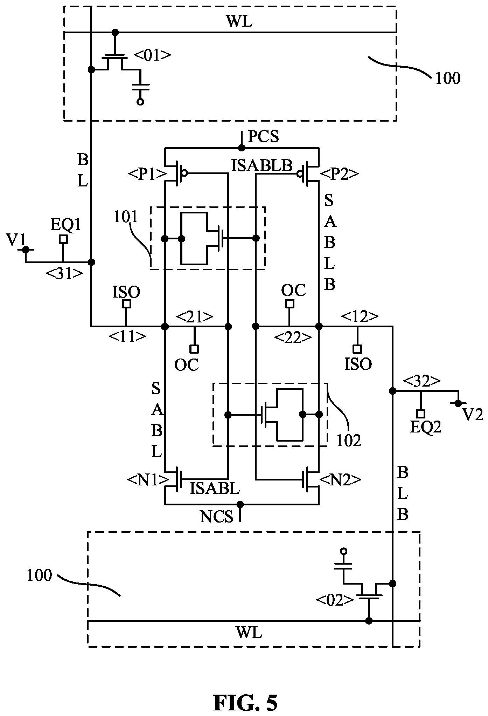

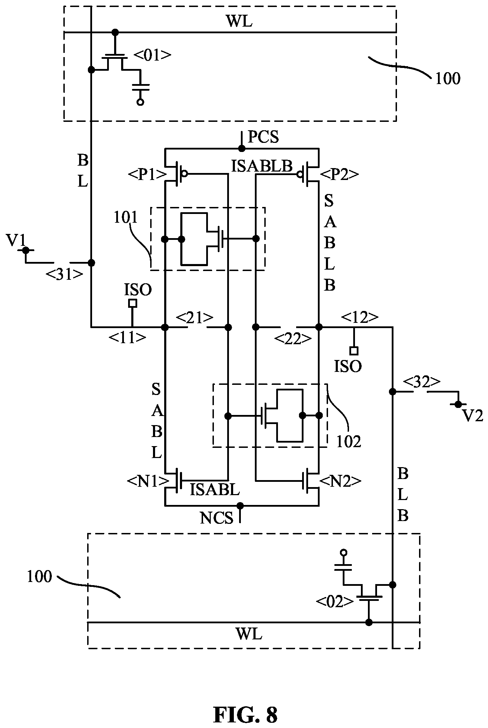

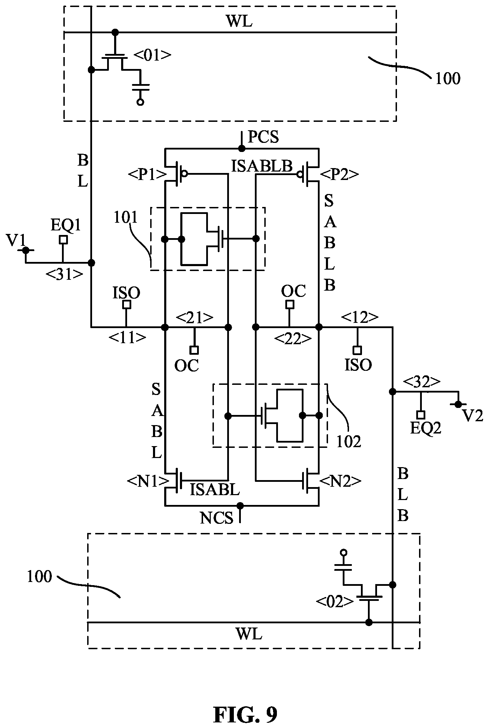

FIG. 4 illustrates a timing diagram of each control signal of a sense amplification circuit in a data reading method according to another embodiment of the present disclosure. FIGS. 5 to 9 illustrate schematic diagrams of the circuit states of each sense amplification circuit corresponding to to a respective stage in a data reading method according to another embodiment of the present disclosure. The following describes the data reading method provided in this embodiment in further detail with reference to the drawings, specifically as follows.

Referring to FIG. 4, the reading stages of the sense amplifier include a first reading stage S1 in the period t0 to t1, a second reading stage S2 in the period t1 to t4, a third reading stage S3 in the period t4 to t5, a fourth reading stage S4 in the period t5 to t6. The second reading stage includes a first processing sub-stage in the period t1 to t2, a second processing sub-stage in the period t2 to t3, and a third processing sub-stage in the period t3 to t4.

For the first reading stage S1, the precharging signal EQ is provided to turn on the precharging unit to precharge the initial bit line BL, the first reading bit line SABL, the second reading bit line ISABL, the complementary bit line BLB, the first reading complementary bit line SABLB, and the second reading complementary bit line ISABLB with reference to the time period t0 to t1 in FIG. 4 and FIG. 5.

Specifically, the precharging signal EQ includes a first precharging signal EQ1 and a second precharging signal EQ2. The first precharging MOS transistor <31> is configured to receive the first precharging signal EQ1. The second precharging MOS transistor <32> is configured to receive the second precharging signal EQ2.

When providing the precharging signal EQ, both an offset cancellation signal OC and an isolation signal ISO are provided.

Specifically, the first isolation MOS transistor <11> and the second isolation MOS transistor <12> are configured to receive the isolation signal ISO. The first offset cancellation MOS transistor <21> and the second offset cancellation MOS transistor <22> are configured to receive the offset cancellation signal OC.

In the first reading stage S1, the first isolation MOS transistor <11> and the second isolation MOS transistor <12> are turned on based on the isolation signal ISO, the first offset cancellation MOS transistor <21> and the second offset cancellation MOS transistor <22> are turned on based on the offset cancellation signal OC, so that the initial bit line BL, the first reading bit line SABL and the second reading bit line ISABL are communicated, and the initial complementary bit line BLB, the first reading complementary bit line SABLB and the second reading complementary bit line ISABLB are communicated.

The first precharging MOS transistor <31> is turned on based on the first precharging signal EQ1 for precharging the initial bit line BL, the first reading bit line SABL, and the second reading bit line ISABL. The second precharging MOS transistor <32> is turned on based on the second precharging signal EQ2 for precharging the initial complementary bit line BLB, the first reading complementary bit line SABLB and the second reading complementary bit line ISABLB. That is, the purpose of the first reading stage S1 is to precharge the sense amplification circuit. In addition, in the precharging stage, the precharging voltage charges the first driving unit 101 and the second driving unit 102.

For the second reading stage S2, referring to the time period t1 to t4 in FIG. 4 and FIGS. 6 and 7, a row selection signal is provided to turn on the selected memory cell, so that the charge stored in the memory cell is shared to the initial bit line BL or the initial complementary bit line BLB.

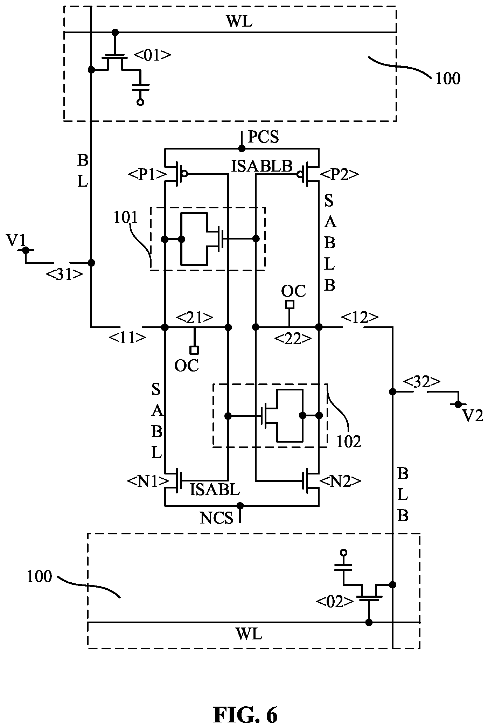

Specifically, for the first processing sub-stage, referring to the time period t1 to t2 in FIG. 4 and FIG. 6, the precharging signal EQ and the isolation signal ISO are turned off, that is, the first isolation unit, the second isolation unit, and the precharging unit are turned off, and the first level signal PCS is provided to the first signal terminal, that is, the electrical signal corresponding to logic "1" is provided, and the second level signal NCS is provided to the second signal terminal, that is, the electrical signal corresponding to logic "0" is provided.

In this case, the voltage received by the gates of the first PMOS transistor <P1> and the second PMOS transistor <P2> belonging to PMOS are the same as the voltage after precharging, but the threshold voltages of the first PMOS transistor <P1> and the second PMOS transistor <P2> are different, so that the first PMOS transistor <P1> and the second PMOS transistor <P2> have different source-drain channel opening degrees, resulting in different equivalent resistances of the first PMOS transistor <P1> and the second PMOS transistor <P2>. The voltage received by the gates of the first NMOS transistor <N1> and the second NMOS transistor <N2> belonging to NMOS are the same as the voltage after precharging. However, the threshold voltages of the first NMOS transistor <N1> and the second NMOS transistor <N2> have different source-drain channel opening degrees, resulting in different equivalent resistances of the first NMOS transistor <N1> and the second NMOS transistor <N2>, thereby trimming the level of the first reading bit line SABL and the level of the first reading complementary bit line SABLB.

For the second processing sub-stage, a row selection signal, that is, a word line signal, is provided to select a memory cell and read data stored in the memory cell onto the initial bit line BL or the initial complementary bit line BLB with reference to the time period t2 to t3 in FIG. 4. The offset cancellation signal OC is continued to be provided when providing the row selection signal. Since the isolation signal ISO is turned off during the first processing sub-stage, the initial bit line BL and the first reading bit line SABL are not communicated, and the initial complementary line BLB is in complementary communication with the first reading complementary bit line SABLB, that is, the level changes of the initial bit line BL and the initial complementary bit line BLB do not affect the execution of the sense amplifier offset cancellation.

As can be seen, the A section (period t1 to t3) of the second reading stage S2 is configured for offset cancellation of the sense amplifier to cancel device differences between the first PMOS transistor <P1> and the second PMOS transistor <P2>, and to cancel device differences between the first NMOS transistor <N1> and the second NMOS transistor <N2>.

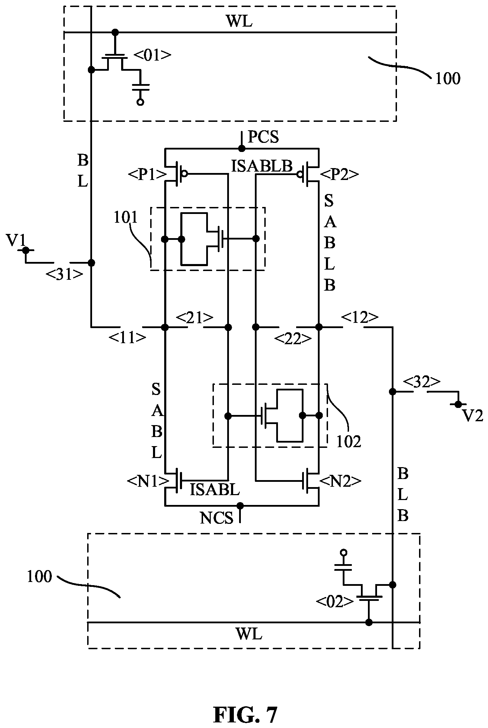

For the third processing sub-stage, referring to the time period t3 to t4 in FIG. 4 and FIG. 7, the offset cancellation signal OC is turned off, and the supply of the first level signal PCS and the second level signal NCS is stopped, that is, the offset cancellation operation of the sense amplifier is stopped.

During this stage, the isolation signal ISO is provided to enable the initial bit line BL to be electrically connected with the first reading bit line SABL, and the initial complementary bit line BLB to be electrically connected with the first reading complementary bit line SABLB. In this case, the initial bit line BL and the first reading bit line SABL share charges, and the initial complementary bit line BLB and the first reading complementary bit line SABLB share charges.

As can be seen, in the B section (time period t2 to t4) of the reading stage S2, the charge of the memory cell to which the initial bit line BL is connected is shared on the first reading bit line SABL, and the charge of the memory cell to which the initial complementary bit line BLB is connected is shared on the first reading complementary bit line SABLB.

For the third reading stage S3, referring to the time period t4 to t5 in FIG. 4 and FIG. 7, that is, the data reading stage of the sense amplifier, in this stage, the first level signal PCS is provided to the first signal terminal, i.e., the electrical signal corresponding to logic "1" is provided to the first signal terminal, and the second level signal NCS is provided to the second signal terminal, i.e., the electrical signal corresponding to logic "0" is provided to the second signal terminal, so that the sense amplification circuit outputs logic "1" or logic "0" corresponding to the data stored in the memory cell. In this process, the offset cancellation signal OC is turned off, and the isolation signal ISO is provided, that is, the first offset cancellation MOS transistor <21> and the second offset cancellation MOS transistor <22> are turned off, and the first isolation MOS transistor <11> and the second isolation MOS transistor <12> are turned on.

When the first isolation MOS transistor <11> and the second isolation MOS transistor <12> are turned on, the levels of the first reading bit line SABL and the first reading complementary bit line SABLB change in the opposite directions, and at this time, in order to delay the level changes of the first reading bit line SABL and the first reading complementary bit line SABLB, the first driving unit 101 and the second driving unit 102 discharge. Since the first reading bit line SABL and the first reading complementary bit line SABLB change in opposite directions, the first driving unit 101 and the second driving unit 102 discharge in opposite directions, causing the second reading bit line ISABL and the second reading complementary bit line ISABLB to change in different directions, thereby when the first PMOS transistor <P1> is turned on, the second NMOS transistor <N2> is also turned on, and when the second PMOS transistor <P2> is turned on, the first NMOS transistor <N1> is also turned on. In this case, the first reading bit line SABL and the first reading complementary bit line SABLB are pulled up to the high level of logic "1" or pulled down to the low level of logic "0" under the action of the first level signal PCS and the second level signal NCS respectively, and are synchronized to the initial bit line BL and the initial complementary bit line BLB, thereby completing the data reading of the memory.

The fourth reading stage S4, that is, the recovery stage of the sense amplification circuit, is also configured to precharge for the next data reading, and the details thereof are the same as those of the first reading stage S1, which is not described herein.

Since the above embodiments correspond to this embodiment, this embodiment can be implemented in cooperation with the above embodiments. The related technical details mentioned in the above embodiments are still valid in this embodiment, and the technical effects that may be achieved in the above embodiments may also be realized in this embodiment. To reduce repetition, details are not described herein. Accordingly, the related technical details mentioned in this embodiment can also be applied to the above embodiments.

For the sake of clarity of description, the above reading stages may be combined into one reading stage or some reading stages may be divided into a plurality of reading stages. As long as the timing change of the control signal is the same, they are within the protection scope of the present patent. Adding insignificant modifications to the reading stage or introducing insignificant designs without changing the core design of the reading stage are within the protection scope of this patent. Those of ordinary skill in the art may understand that the above embodiments are specific embodiments for realizing the present disclosure, and in actual applications, various changes may be made to them in form and details without departing from the spirit and scope of the present disclosure.

## Claims

1. A sense amplification circuit arranged between adjacent memory arrays, comprising:
a first positive channel metal oxide semiconductor, PMOS, transistor, a source of which being connected to a first signal terminal, wherein the first signal terminal is configured to receive a first level signal;
a first negative channel metal oxide semiconductor, NMOS, transistor, a source of which being connected to a second signal terminal, wherein the second signal terminal is configured to receive a second level signal, and the first level signal is greater than the second level signal, wherein a drain of the first PMOS transistor and a drain of the first NMOS transistor are connected to a first reading bit line, and a gate of the first PMOS transistor and a gate of the first NMOS transistor are connected to a second reading bit line;
a second PMOS transistor, a source of which being connected to the first signal terminal;
a second NMOS transistor, a source of which being connected to the second signal terminal, wherein a drain of the second PMOS transistor and a drain of the second NMOS transistor are connected to a first reading complementary bit line, and a gate of the second PMOS transistor and a gate of the second NMOS transistor are connected to a second reading complementary bit line;
a first conduction unit, one terminal of which being connected to the first reading bit line, and other terminal of which being connected to an initial bit line, wherein the initial bit line is connected to a memory cell of one memory array of the adjacent memory arrays;
a second conduction unit, one terminal of which being connected to the first reading complementary bit line, and other terminal of which being connected to an initial complementary bit line, wherein the initial complementary bit line is connected to a memory cell of other memory array of the adjacent memory arrays;
a first driving unit, one terminal of which being connected to the first reading bit line, and other terminal of which being connected to the second reading complementary bit line, to turn on the first PMOS transistor or the first NMOS transistor; and
a second driving unit, one terminal of which being connected to the first reading complementary bit line, and other terminal of which is connected to the second reading bit line, to turn on the second PMOS transistor or the second NMOS transistor.

2. The sense amplification circuit according to claim 1, wherein the first driving unit comprises a first driving metal oxide semiconductor, MOS, transistor;
a source and a drain of the first driving MOS transistor are connected to the first reading bit line, and a gate of the first driving MOS transistor is connected to the second reading complementary bit line; or
a source and a drain of the first driving MOS transistor are connected to the second reading complementary bit line, and a gate of the first driving MOS transistor is connected to the first reading bit line.

3. The sense amplification circuit according to claim 1, wherein the second driving unit comprises: a second driving MOS transistor;
a source and a drain of the second driving MOS transistor are connected to the first reading complementary bit line, and a gate of the second driving MOS is connected to the second reading bit line; or
a source and a drain of the second driving MOS transistor are connected to the second reading bit line, and the gate of the second driving MOS is connected to the first reading complementary bit line.

4. The sense amplification circuit according to claim 1, wherein:
the first driving unit comprises a first driving capacitance, one terminal of the first driving capacitance is connected to the first reading bit line, and other terminal of the first driving capacitance is connected to the second reading complementary bit line; and
the second driving unit comprises a second driving capacitance, one terminal of the second driving capacitance is connected to the first reading complementary bit line, and other terminal of the second driving capacitance is connected to the second reading bit line.

5. The sense amplification circuit according to claim 1, wherein the first conduction unit comprises a first isolation MOS transistor, and the second conduction unit comprises a second isolation MOS transistor;
a source of the first isolation MOS transistor is connected to the first reading bit line, and a drain of the first isolation MOS transistor is connected to the initial bit line;
a source of the second isolation MOS transistor is connected to the first reading complementary bit line, and a drain of the second isolation MOS transistor is connected to the initial complementary bit line; and
a gate of the first isolation MOS transistor and a gate of the second isolation MOS transistor are configured to receive an isolation signal, and enable, based on the isolation signal, the initial bit line to be electrically connected with the first reading bit line, and the initial complementary bit line to be electrically connected with the first reading complementary bit line.

6. The sense amplification circuit according to claim 1, further comprising: a first offset cancellation unit and a second offset cancellation unit, wherein the first reading bit line is connected to the second reading bit line through the first offset cancellation unit, and the first reading complementary bit line is connected to the second reading complementary bit line through the second offset cancellation unit.

7. The sense amplification circuit according to claim 6, wherein the first offset cancellation unit comprises a first offset cancellation MOS transistor, and the second offset cancellation unit comprises a second offset cancellation MOS transistor,
a source of the first offset cancellation MOS transistor is connected to the first reading bit line, and a drain of the first offset cancellation MOS transistor is connected to the second reading bit line;
a source of the second offset cancellation MOS transistor is connected to the first reading complementary bit line, and a drain of the second offset cancellation MOS transistor is connected to the second reading complementary bit line; and
a gate of the first offset cancellation MOS transistor and a gate of the second offset cancellation MOS transistor are configured to receive an offset cancellation signal, and enable, based on the offset cancellation signal, a device difference between the first PMOS transistor and the second PMOS transistor to be cancelled and a device difference between the first NMOS transistor and the second NMOS transistor to be canceled.

8. The sense amplification circuit according to claim 1, further comprising a precharging unit configured to, according to a precharging signal, precharge the initial bit line, the first reading bit line, the second reading bit line, the initial complementary bit line, the first reading complementary bit line, and the second reading complementary bit line to a preset voltage.

9. The sense amplification circuit according to claim 8, wherein the precharging signal comprises a first precharging signal and a second precharging signal, the preset voltage comprises a first preset voltage and a second preset voltage, and the precharging unit comprises:
a first precharging MOS transistor configured to, according to the first precharging signal, precharge a voltage of the initial bit line, a voltage of the first reading bit line, and a voltage of the second reading bit line to the first preset voltage; and
a second precharging MOS transistor configured to, according to the second precharging signal, precharge a voltage of the initial complementary bit line, a voltage of the first reading complementary bit line and a voltage of the second reading complementary bit line to the second preset voltage.

10. The sense amplification circuit according to claim 9, wherein a gate of the first precharging MOS transistor is configured to receive the first precharging signal, a source of the first precharging MOS transistor is configured to receive the first preset voltage, and a drain of the first precharging MOS transistor is connected to the initial bit line; a gate of the second precharging MOS transistor is configured to receive the second precharging signal, a source of the second precharging MOS transistor is configured to receive the second preset voltage, and a drain of the second precharging MOS transistor is connected to the initial complementary bit line.

11. The sense amplification circuit according to claim 9, wherein the first precharging signal is the same as the second precharging signal.

12. The sense amplification circuit according to claim 9 or 11, wherein the first preset voltage is the same as the second preset voltage.

13. A data reading method based on the sense amplification circuit according to any one of claims 1 to 12, comprising:
providing a row selection signal to turn on a selected memory cell; and
providing an electrical signal corresponding to logic "1" to the first signal terminal, and providing an electrical signal corresponding to logic "0" to the second signal terminal.

14. The data reading method according to claim 13, wherein the sense amplification circuit further comprises a precharging unit, and the method further comprises: before providing the row selection signal and the column selection signal,
providing a precharging signal to turn on the precharging unit.

15. The data reading method according to claim 14, wherein the sense amplification circuit further comprises a first isolation unit, a second isolation unit, a first offset cancellation unit, and a second offset cancellation unit;
providing both an offset cancellation signal and an isolation signal when providing the precharging signal,
wherein the method further comprises: before providing the row selection signal and after providing the precharging signal,
turning off the first isolation unit, the second isolation unit and the precharging unit, and providing the electrical signal corresponding to logic "1" to the first signal terminal, and providing the electrical signal corresponding to logic "0" to the second signal terminal;
providing the offset cancellation signal when providing the row selection signal;
turning off the offset cancellation signal and providing the isolation signal when providing the electrical signal corresponding to logic "1" to the first signal terminal and providing the electrical signal corresponding to logic "0" to the second signal terminal.
